# EUROPEAN PATENT SPECIFICATION

(11) **EP 2 256 565 B1**
(45) Date of publication and mention of the grant of the patent: **03.07.2013**
(21) Application number: 10164198.3
(22) Date of filing: 27.05.2010
(51) Int. Cl.: G05B 19/042, G05B 9/03

(54) **System for sending signals between modules**
System zum Senden von Signalen zwischen Modulen
Système pour l'envoi de signaux entre modules

(30) Priority: 28.05.2009 JP 2009128921
(43) Date of publication of application: 01.12.2010
(73) Proprietor: Azbil Corporation, Chiyoda-ku Tokyo (JP)
(72) Inventor: Yamada, Akira, Tokyo 100-6419 (JP); Kumazawa, Yuuichi, Tokyo 100-6419 (JP); Morikawa, Katsumi, Tokyo 100-6419 (JP)
(74) Representative: Tomlinson, Kerry John

(56) References cited:
- EP-A1- 0 798 895
- WO-A2-98/44399
- DE-A1- 4 339 569
- DE-A1- 4 341 082
- DE-A1- 10 065 907
- MAXIM: 'Datasheet: MAXIM Low Power, Slew-Rate-Limited RS-485/RS-422 Transceivers' 31 October 2003, 120 SAN GABRIEL DRIVE, SUNNYVALE, CA 94086, USA, XP055037225

## Description

### BACKGROUND OF THE INVENTION

### Technical Field

The present invention relates to a system for sending signals between modules, capable of reliably sending, for example, information regarding the actuation of a safety device between modules.

### Related Art

An operating control system for a combustion furnace is provided with a monitoring module for monitoring interlocks pertaining to safety operations of the combustion furnace, and a combustion control module for controlling the operation of the burner in the combustion furnace. Furthermore, in the monitoring module, interlocks pertaining to safety operations of the combustion furnace are monitored; only when the interlocks are in the normal state, a "burner operation permission" signal is sent to the combustion control module from the monitoring module; and then the operation and the control of the burner is activated. In this case, if, in the monitoring module, the interlocks are not in the normal state, it is important that the "burner operation permission" signal not be outputted. It is also important that, in the combustion control module, the "burner operation permission" signal be recognized reliably.

Signals pertaining to these types of safety operations must be transmitted reliably, and, for example, JP-A- 2001-133502 discloses detecting a failure in a harness (an open line, a ground fault, or the like) by providing a voltage divider circuit at both ends of the harness, when transmitting two types of signals, "H" and "L", through a harness. However, JP-A- 2001-133502 merely disclose coping with failures in the harness.

WO 98/44399 discloses a method for programming a safety control system with centralized and/or decentralized stations. The stations each comprise two channels wherein each channel comprises a power pack and a programmable control unit which are connected to bus controllers that are connected with bus couplers to a bus data line. Data exchange takes place between the two channels via a connecting link between the two control units.

However, in transmitting the aforementioned signals pertaining to safety operations between modules, it is important that the "burner operation permission" signal be outputted (transmitted) only when the interlocks on the sending module (the monitoring module) are normal. Accordingly, one may consider increasing the reliability by providing, in parallel, a plurality of controllers that each output the "burner operation permission" signal when the interlocks are normal, for example, and performing the transmission only when the controllers all output the "burner operation permission" signal.

On the other hand, in the receiving module (the combustion control module), it is important to recognize accurately that the signal for which the transmission has been received is the "burner operation permission" signal. In contrast, instead of simply providing, for example, an "H" level or an "L" level signal (voltage) to the "burner operation permission" signal, one may consider having the signal itself be a pulse signal of a specific period, and adding to the signal element whether or not there is a skip in the pulse signal, to thereby transmit the information reliably.

However, even in using the pulse signal described above, the reliable generation of a pulse signal is not necessarily limited to a case where the interlocks are normal. That is, one may also consider the case where the pulse generating circuit is malfunctioning. Accordingly, one may consider controlling the output of the pulse signal using a relay, together with control for reducing the pulse signal depending on the interlocks. However, when a relay is used in parallel, there are the new problems of not being able to control the output of the pulse signal due to a failure of a relay (that is, when a relay contact point fuses).

### SUMMARY OF THE INVENTION

Accordingly, it is an illustrative aspect of the present invention to provide a system for transmitting signals between modules that enables reliable transmission, between modules, of information pertaining to the actuation of safety mechanisms.

According to one or more illustrative aspects of the present invention, there is provided a system for transmitting signals between modules. The system includes: a sending module configured to send a pulse signal having a certain period that represents certain information; and a receiving module configured to receive the pulse signal from the sending module to detect the certain information. The sending module includes: a plurality of signal generators provided in parallel so as to generate pulse signals in a time-division manner; a pulse signal converter configured to convert the pulse signals generated by the signal generators into a single time series pulse signal; a relay including: a common terminal, wherein the single time series pulse signal is inputted to the common terminal; a normally-closed terminal electrically connected to the common terminal in a non-driven state of the relay; and a normally-open terminal electrically connected to the common terminal in a driven state of the relay, wherein the single time series pulse signal is outputted from the normally-open terminal to the receiving module, a relay driving unit configured to drive the relay only when all of the signal generators are operating to generate the pulse signals. The signal generators are configured to detect whether the single time series pulse signal is present in the normally-open terminal side and whether the single time series pulse signal is present in the normally-closed terminal side, so as to determine a failure in the single time series pulse signal that is outputted to the receiving module, and the signal generators stop generation of the pulse signals in determining that there is a failure in the single time series pulse signal.

According to one or more illustrative aspects of the present invention, the receiving module is configured to determine that there is the certain information in the single time series pulse signal when the single time series pulse signal continues over a predetermined time interval.

According to one or more illustrative aspects of the present invention, the signal generators determine that there is no failure in the single time series pulse signal, if the single time series pulse signal is outputted from only the normally-open terminal when driving the relay and if the single time series pulse signal is outputted from only the normally-closed terminal when stopping driving of the relay. The signal generators determine that there is a failure in the single time series pulse signal, unless the single time series pulse signal is outputted from only the normally-open terminal when driving the relay and the single time series pulse signal is outputted from only the normally-closed terminal when stopping driving of the relay.

According to one or more illustrative aspects of the present invention, the signal generators determine that there is a failure in the single time series pulse signal, if the single time series pulse signal is outputted from both the normally-open terminal and the normally-closed terminal when stopping driving of the relay.

Given the structure set forth above, the sending module generates a single time series pulse signal by a combining pulse signals generated alternatingly through time division by the plurality of signal generators and this time series pulse signal is transmitted to the receiving module through a relay, enabling the easy and reliable identification of an interruption in the signal that indicates the presence of data, from a skip in the pulse signal on the receiving module. Furthermore, on the sending module, the monitoring of the signals (pulse signals) that appear, respectively, at the normally-open contact point and the normally-closed contact point of the relay when the relay is driven and when the relay is not driven enables the easy evaluation as to whether or not a failure has occurred in the relay, or the like (that is, a self-diagnostic function). Consequently, stopping the pulse signal generating operation itself when a failure has occurred can prevent effectively the transmission of an incorrect signal to the receiving module.

### BRIEF DESCRIPTION OF THE DRAWINGS

FIG. 1 is a diagram showing an example of a sending module and a receiving module for achieving the system for transmission of signals between modules according to an embodiment of the present invention;
FIG. 2 is a timing chart illustrating the operation mode in a normal state;
FIG. 3 is a timing chant illustrating the operation mode in an abnormal state in which the common contact point and the normally-open contact point of the relay are fused together; and
FIG. 4 is a timing chart illustrating the operation mode in an abnormal state in which the common contact point, the normally-open contact point, and the normally-closed contact point of the relay are fused together.

### DETAILED DESCRIPTION OF EXEMPLARY EMBODIMENTS

The system for transmitting signals between modules according to an embodiment will be now described with reference to the drawings.

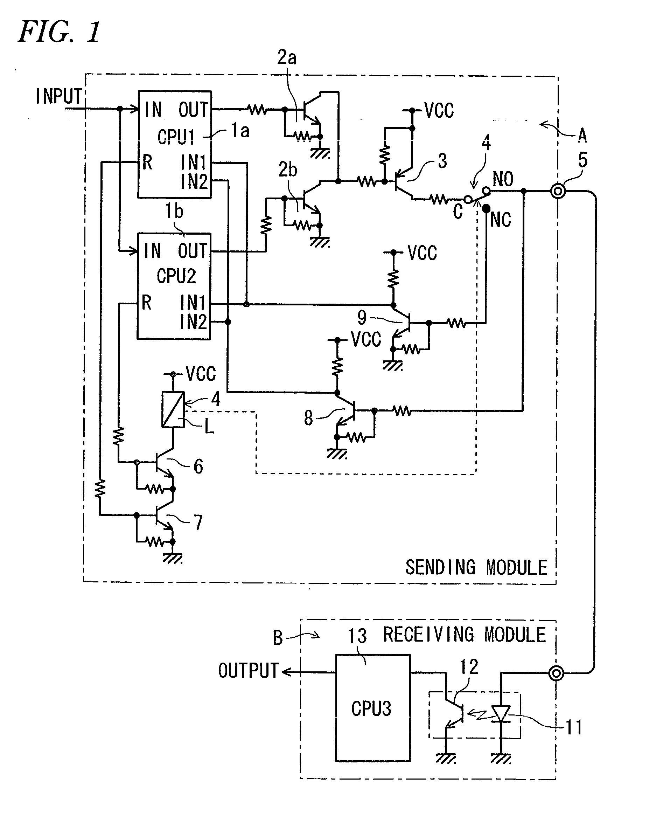

FIG. 1 is a diagram illustrating a transmitting module and a receiving module for achieving the system for transmitting signals between modules. In FIG. 1, A is a transmitting module (monitoring module) for monitoring interlocks in, for example, a combustion furnace and for outputting a "burner operation permission" signal, and B is a receiving module (combustion controlling module) for receiving the "burner operation permission" signal and controlling the combustion of the burner.

The transmitting module A is provided with two controllers (CPUs) 1a and 1b, in parallel, that receive interlock signals and generate pulse signals of specific periods, where information (pulse signal) indicating the existence of an interlock signal is generated in a multiplex (duplex) manner, to increase the reliability of the information (the pulse signal). The controllers (CPUs) 1a and 1b fundamentally have various roles (such as the process for purging the combustion furnace) in the control of operation (the combustion control) of the combustion furnace, and perform the function as a signal generator for generating, through time division, pulse signals which, in general, operate synchronized with each other in providing notification of the "burner operation permission" to the receiving module (the combustion controlling module) B, as described above.

Specifically, each of the individual controllers (CPUs) 1a and 1b generates pulse signals e.g. with periods of 20 ms, shaped in square waves with a 50% duty cycle, in bursts alternatingly between the controllers every 100 ms, for example. Then, the respective pulse signals that are outputted from the individual controllers (CPUs) 1a and 1b are combined together through a logical adding circuit (a pulse signal converter) that includes transistors 2a and 2b to generate a pulse signal (pulse signal train) that continues in a time series with a specific driver, which is transmitted to the receiving module B side through an output transistor 3.

A relay (switch) 4, for controlling the external outputting of a pulse signal that is outputted from the output transistor 3, is provided in series in the output stage of the transmitting module A, where it is only when this relay 4 is ON (when driven) that the pulse signal is outputted to the outside through the normally-open contact point (NO). Specifically, this relay 4 is of a type wherein the common terminal C is connected to the normally-closed contact point (and C) side when an electromagnetic coil L is not driven (when OFF), and the common terminal C is switched to be connected to the normally-open contact point NO side when a current is driven for the electromagnetic coil L (when ON).

Accordingly, in the present embodiment, the common contact point C of the relay 4 is connected to the output terminal (the collector of a PNP transistor 3 wherein the emitter is connected to the supply) of the output transistor 3, when the normally-open contact point NO is connected to the external output terminal 5. Consequently, by driving the current in the relay 4, a time series pulse signal wherein the outputs from the controlling devices 1a and 1b are gathered together into a single pulse signal, through logical adding circuits (transistors 2a and 2b) is transmitted to the receiving module B through the normally-open contact point NO of the relay 4 from the output transistor 3.

The electromagnetic coil L of the relay 4 is controlled through a relay driving circuit including two transistors 6 and 7 connected in series, having the conductivities thereof driven through the reception of relay driving signals from the controllers 1a and 1b. Consequently, the relay 4 is driven through the relay controlling circuit (transistors 6 and 7) only when the relay driving signals are outputted simultaneously from the controlling devices 1a and 1b. Additionally, if one or both of the controlling devices 1a a and 1b were to stop outputting the relay driving signal, then the OFF operation by either the transistor 6 or the transistor 7 would stop the operation of the entire relay 4.

Furthermore, the transmitting module A is provided with a transistor 8 as a monitoring circuit for monitoring the pulse signal that is outputted to the outside through the normally-open contact point NO of the relay 4, and a transistor 9 as a monitoring circuit for monitoring the pulse signal that should appear at the normally-closed contact point NC of the relay 4 when the relay 4 is in a non-driven state. Accordingly, the pulse signals that are detected through the respective transistors 8 and 9 (monitoring circuits) are applied respectively to the individual controllers 1a and 1b as the output monitoring results in1 and in2, so as to provide a self-diagnostic for the function of the transmitting module A.

The receiving module B, as described above, is configured to detect, through a photocoupler that includes a light-emitting element 11 and a light-detecting element 12 that is optically coupled to the light-emitting element 11, the pulse signal transmitted from the transmitting module A. The controlling device 13 that receives this signal is configured to recognize the received pulse signal as the "burner operation permission" signal, when the pulse signal continues over at least a specific period of time (for example, 500 ms). In other words, if the continuous time interval for the pulse signal does not fulfill the set time interval (for example, 500 ms), then the controlling device 13 determines that the "burner operation permission" signal has been canceled, or that the "burner operation permission" signal was not sent due to a failure of some sort in the transmitting module A.

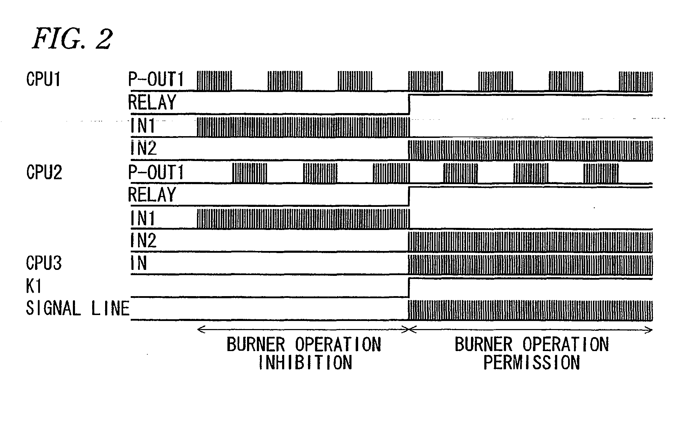

The failure detecting process in the transmitting module A will be now described. When all of the individual elements of the transmitting module A, such as the relay 4, are operating properly, then alternating pulse signals are outputted at specific time intervals, as illustrated in, for example, FIG. 2, depending on the input of the interlock signals from the two controllers (CPUs) 1 and 2 that are provided in parallel. However, during the interval until the controllers 1 and 2 determine that the transmitting module A is functioning properly, the relay 4 is not driven. Consequently, the pulse signals that are outputted from the individual controllers 1 and 2, as described above, are combined into a single time series pulse signal through a logical adding circuit (transistors 2a and 2b), where this time series pulse signal is provided from the output transistor 3 to the relay contacts 4.

However, when the relay 4 is in a normal state and not driven, the pulse signal is provided from the normally-closed contact point side of the relay 4 ( not the normally-open contact point NO side). As a result, as illustrated in FIG. 2, the pulse signal that is detected from the normally-closed contact point NC side of the relay 4 will be provided to the first monitoring input port in1 of the controllers 1 and 2 (not the second monitoring input port in2). The individual controlling devices 1 and 2 determine, based on this type of monitoring result, that the relay 4 is in a normal state, and then provide a driving signal to the relay 4.

Then, the transistors 6 and 7 of the relay driving circuits receive these relay driving signals to drive the relay 4, thereby switching the output contact point. As a result, as illustrated in FIG. 2, the time series pulse signal combined together as described above is sent to the receiving module B side through the external contact terminal 5 from the normally-open contact point NO side of the relay 4. Simultaneously, the pulse signal is not sent to the normally-closed contact point NC side of the relay 4. That is, the pulse signal is not provided to the first monitoring input port in1 in each of the controllers 1 and 2. Instead of this, the pulse signal is provided to the second monitoring input port in2. The controllers 1 and 2 determine that the relay 4 is operating properly, based on these monitoring results.

The pulse signal that is transmitted to the receiving module B side through the external contact terminal 5 is a single combined continuous pulse signal generated by combining the respective pulse signals that are generated in the controllers 1 and 2, and thus indicates the "burner operation permission" signal. Consequently, there will be no outputting of a "burner operation permission" signal unintentionally from the transmitting module A.

In a case where the pulse signal is not generated properly from either one of the controllers 1 or 2, or a case where there is a failure of a transistor 2a or 2b as the pulse signal converter, then, as described above, the single combined time series pulse signal will not be generated and supplied to the input ports in1. Consequently, in such a case it will be determined that there has been a failure on the side of one of the controllers 1 or 2, and thereafter the pulse signal generation will be terminated. Furthermore, if the pulse signal itself is not detected in activating the controllers 1 and 2, it will be determined that some kind of failure has occurred.

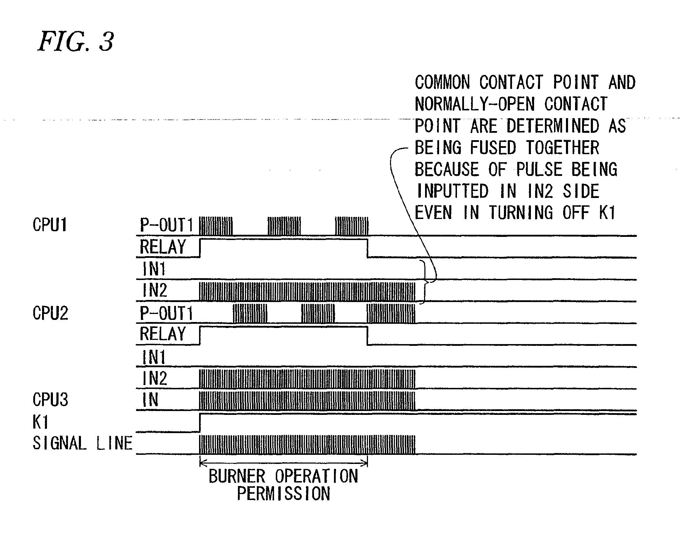

Also, a contact point fault in the relay 4 may be generated through fusing between contact points, caused by electric discharge between the contact points, when the relay 4 is driven. Consequently, in detecting the fault in the relay 4, the driving should be stopped from a state wherein the relay 4 is driven, and, at that time, the monitoring states in the first and second monitoring input ports in1 and in2 should be checked. Specifically, if the common contact point C and the normally-open contact point NO of the relay 4 have been fused together, then even when the driving of the relay 4 has been stopped, the movable contact piece does not return to the normally-closed contact point NC side. As a result, in this case the outputting of the pulse signal to the normally-open contact point NO side (the first monitoring input port in2) will continue regardless of the driving of the relay 4 having been stopped, as illustrated in FIG. 3, and, on the other hand, the pulse signal will not appear on the normally-closed contact point NC side of the relay 4 (the first monitoring input portin 1).

Consequently, each of the controllers 1 and 2 determines that a failure has occurred in the relay 4, based on the monitoring results, and, for example, the generation of the pulse signals itself is stopped. As a result, the transmission of the pulse signal to the receiving module B is forcibly terminated. In particular, even in a case where the driving of the relay 4 has been stopped and the transmission of the pulse signal should be terminated, if there is a failure in the relay 4, this stops the generation of the pulse signal itself in the controllers 1 and 2, thereby prohibiting the transmission of the pulse signal to the receiving module B thereafter.

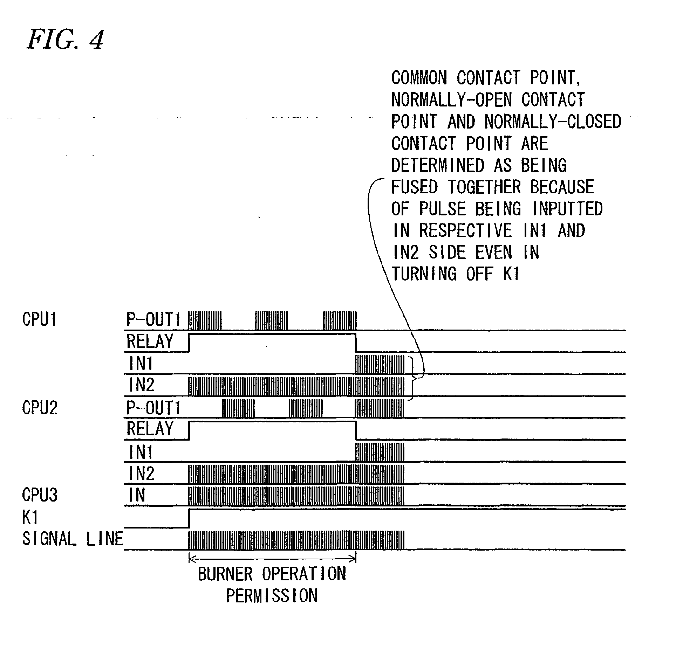

As one mode of failure of the relay 4, there is a case wherein, in addition to the normally-open contact point NO being fused to the common contact point C, the normally-closed contact point NC is also, simultaneously, fused thereto. Because of this, when such a situation occurs, the outputting of the pulse signal from the normally-open contact point NO side of the relay 4 (the monitoring input port in2) will continue, as illustrated in FIG. 4, and the pulse signal will also appear at the normally-closed contact point NC side of the relay 4 (the monitoring input port in1), regardless of the relay 4 being driven or the driving thereof having been stopped. Consequently, it may be determined in each of the controllers 1 and 2, based on these monitoring results as well, that a failure has occurred in the relay 4, and the pulse signal generation itself may be stopped, to forcibly terminate the transmission of the pulse signal to the receiving module B.

That is, in the transmission module as described above, if the burner operation is permitted or prohibited through controlling the driving of the relay 4 by the state wherein pulse signals are generated alternatingly from the two controllers 1 and 2, then, when there is no failure, the pulse signal will be detected only on the normally-open contact point NO side of the relay 4 (the monitoring input port in2) while the burner operation is permitted, and, conversely, while the burner operation is prohibited, the pulse signal will be detected only on the normally-closed contact point NC side (the monitoring input port in1), and thus if any other status appears, it is then possible to detect this as some kind of failure having occurred in the transmitting module A. Additionally, the pulse signal is prevented from being generated from the controllers 1 and 2 when a failure is detected, and thus it is possible to prevent the transmission of incorrect information to the receiving module B.

When a failure has occurred in one of the two controllers 1 and 2, then the pulse signal from the controller on the side wherein the failure has occurred is not outputted. Consequently, even if there is a time series conversion of the pulse signals through the logical adding circuit (the transistors 2a and 2b), that output will only be those pulse signals outputted from the one controller. Consequently, there will be intermittent skips in the pulse signal of the predetermined period, making it possible to detect the failure of the other controller. Consequently, prohibiting the generation of the pulse signal in the controller on the side that is functioning properly enables the reliable prevention of the outputting of an incorrect pulse signal from the transmitting module A.

As described above, if there is a fault in a transistor 2a, 2b, or 3, then it will not be possible to obtain the single combined continuous time series pulse signal. Furthermore, if there is a fault in a transistor 6 or 7, then the relay 4 cannot be turned ON or OFF. Consequently, monitoring the signals that are detected by the monitoring input ports in1 and in2, described above, makes it possible to detect even this type of failure. Consequently, it is possible to transmit reliably the "burner operation permission" information to the receiving module B as a continuous pulse signal over at least a specific time period exclusively when the transmitting module A is functioning properly.

The present invention is not limited to the above-described embodiment. For example, three or more controllers may be provided in parallel, and the pulse signal may be generated in a multiplex manner. Additionally, a variety of different forms for, for example, the period with which the pulse signals are generated, are possible in accordance with the application for the information transmission. Furthermore, when generating the pulse signals alternatingly from the two controllers 1a and 1b, it is possible to control the generation of the pulse signals in a complementary manner by the two controllers 1a and 1b, or the timing with which the pulse signals are generated may be set automatically while counting the number of pulses in the pulse signals generated by another controller. Various embodiments are available within the scope of the invention, which is defined by the claims.

Constituent components disclosed in the aforementioned embodiments may be combined suitably to form various modifications. For example, some of all constituent components disclosed in one of the embodiments may be removed or the constituent components disclosed in different embodiments may be appropriately combined.

## Claims

1. A system for transmitting signals between modules, the system comprising:
a sending module (A) configured to send a pulse signal having a certain period that represents certain information; and
a receiving module (B) configured to receive the pulse signal from the sending module to detect the certain information,
wherein the sending module comprises:
a plurality of signal generators (1a,1b) provided in parallel so as to generate pulse signals in a time-division manner; and
a pulse signal converter (2a,2b,3) configured to convert the pulse signals generated by the signal generators into a single time series pulse signal;
wherein the signal generators stop generation of the pulse signals in determining that there is a failure in the single time series pulse signal;
**characterised in that** the sending module comprises a relay (4) comprising:
a common terminal (C), wherein the single time series pulse signal is inputted to the common terminal;
a normally-closed terminal (NC) electrically connected to the common terminal in a non-driven state of the relay;
a normally-open terminal (NO) electrically connected to the common terminal in a driven state of the relay, wherein the single time series pulse signal is outputted from the normally-open terminal to the receiving module, and
a relay driving unit (6,7) configured to drive the relay only when all of the signal generators are operating to generate the pulse signals, and
**in that** the signal generators are configured to detect whether the single time series pulse signal is present in the normally-open terminal side and whether the single time series pulse signal is present in the normally-closed terminal side, so as to determine a failure in the single time series pulse signal that is outputted to the receiving module.

2. The system according to Claim 1,
wherein the receiving module (B) is configured to determine that there is the certain information in the single time series pulse signal when the single time series pulse signal continues over a predetermined time interval.

3. The system according to Claim 1 or 2,
wherein the signal generators (1a,1b) determine that there is no failure in the single time series pulse signal, if the single time series pulse signal is outputted from only the normally-open terminal (NO) when driving the relay (4) and if the single time series pulse signal is outputted from only the normally-closed terminal (NC) when stopping driving of the relay, and
wherein the signal generators determine that there is a failure in the single time series pulse signal, unless the single time series pulse signal is outputted from only the normally-open terminal when driving the relay and the single time series pulse signal is outputted from only the normally-closed terminal when stopping driving of the relay.

4. The system according to Claim 1, 2 or 3,
wherein the signal generators (1a,1b) determine that there is a failure in the single time series pulse signal, if the single time series pulse signal is outputted from both the normally-open terminal and the normally-closed terminal when stopping driving of the relay.

## Patentansprüche

1. System zum Senden von Signalen zwischen Modulen, wobei das System Folgendes umfasst:
ein Sendemodul (A), das dazu konfiguriert ist, ein Impulssignal mit einer bestimmten Periodendauer, die eine bestimmte Information darstellt, zu senden, und
ein Empfangsmodul (B), das dazu konfiguriert ist, das Impulssignal von dem Sendemodul zu empfangen, um die bestimmte Information zu erfassen,
wobei das Sendemodul Folgendes umfasst:
mehrere Signalgeneratoren (1a, 1 b), die parallel vorgesehen sind, um in einem Zeitmultiplexverfahren Impulssignale zu erzeugen, und
einen Impulssignalwandler (2a, 2b, 3), der dazu konfiguriert ist, die von den Signalgeneratoren erzeugten Impulssignale in ein einzelnes Zeitreihenimpulssignal umzuwandeln,
wobei die Signalgeneratoren das Erzeugen der Impulssignale bei Feststellung einer Störung in dem einzelnen Zeitreihenimpulssignal beenden,
**dadurch gekennzeichnet, dass** das Sendemodul ein Relais (4) umfasst, Folgendes umfassend:
einen gemeinsamen Pol (C), wobei das einzelne Zeitreihenimpulssignal in den gemeinsamen Pol eingegeben wird,
einen Öffner (NC), der elektrisch mit dem gemeinsamen Pol in einem nicht angetriebenen Zustand des Relais verbunden ist,
einen Schließer (NO), der elektrisch mit dem gemeinsamen Pol in einem angetriebenen Zustand des Relais verbunden ist, wobei das einzelne Zeitreihenimpulssignal von dem Schließer an das Empfangsmodul ausgegeben wird, und
einen Relaisantrieb (6, 7), der dazu konfiguriert ist, das Relais nur anzutreiben, wenn alle der Signalgeneratoren in Betrieb sind, um Impulssignale zu erzeugen, und
dadurch, dass die Signalgeneratoren dazu konfiguriert sind zu erfassen, ob das einzelne Zeitreihenimpulssignal auf der Seite des Schließers vorhanden ist und ob das einzelne Zeitreihenimpulssignal auf der Seite des Öffners vorhanden ist, um eine Störung in dem an das Empfangsmodul ausgegebenen einzelnen Zeitreihenimpulssignal zu ermitteln.

2. System nach Anspruch 1,
wobei das Empfangsmodul (B) so konfiguriert ist zu ermitteln, dass die bestimmte Information in dem einzelnen Zeitreihenimpulssignal vorliegt, wenn das einzelne Zeitreihenimpulssignal sich über ein zuvor bestimmtes Zeitintervall fortsetzt.

3. System nach Anspruch 1 oder 2,
wobei die Signalgeneratoren (1a, 1 b) ermitteln, dass keine Störung in dem einzelnen Zeitreihenimpulssignal vorliegt, falls das einzelne Zeitreihenimpulssignal nur von dem Schließer (NO) ausgegeben wird, wenn dieser das Relais (4) antreibt, und falls das einzelne Zeitreihenimpulssignal nur von dem Öffner (NC) ausgegeben wird, wenn der Relaisantrieb gestoppt wird, und
wobei die Signalgeneratoren ermitteln, dass eine Störung in dem einzelnen Zeitreihenimpulssignal vorliegt, sofern das einzelne Zeitreihenimpulssignal nicht von nur dem Schließer (NO) ausgegeben wird, wenn er das Relais antreibt, und das einzelne Zeitreihenimpulssignal nur von dem Öffner (NC) ausgegeben wird, wenn der Relaisantrieb gestoppt wird.

4. System nach Anspruch 1, 2 oder 3,
wobei die Signalgeneratoren (1a, 1b) feststellen, dass eine Störung in dem einzelnen Zeitreihenimpulssignal vorliegt, wenn das einzelne Zeitreihenimpulssignal sowohl von dem Schließer als auch von dem Öffner ausgegeben wird, wenn der Relaisantrieb gestoppt wird.

## Revendications

1. Système pour transmettre des signaux entre des modules, le système comprenant :
un module d'envoi (A) configuré pour envoyer un signal à impulsions ayant une certaine période qui représente certaines informations ; et
un module de réception (B) configuré pour recevoir le signal à impulsions en provenance du module d'envoi pour détecter les certaines informations,
dans lequel le module d'envoi comprend :
une pluralité de générateurs de signal (1a, 1b) disposés en parallèle de façon à produire des signaux à impulsions d'une façon par répartition dans le temps ; et
un convertisseur de signal à impulsions (2a, 2b, 3) configuré pour transformer les signaux à impulsions produits par les générateurs de signal en un signal à impulsions de série temporelle unique ;
dans lequel les générateurs de signal arrêtent la production des signaux à impulsions en déterminant qu'il y a une défaillance dans le signal à impulsions de série temporelle unique ;
**caractérisé en ce que** le module d'envoi comprend un relais (4) comprenant :
une borne commune (C), dans lequel le signal à impulsions de série temporelle unique est entré dans la borne commune ;
une borne normalement fermée (NC) électriquement reliée à la borne commune dans un état non piloté du relais ;
une borne normalement ouverte (NO) électriquement reliée à la borne commune dans un état piloté du relais, dans lequel le signal à impulsions de série temporelle unique est sorti depuis la borne normalement ouverte vers le module de réception, et
une unité de pilotage de relais (6, 7) configurée pour piloter le relais seulement quand tous les générateurs de signal fonctionnent pour produire les signaux à impulsions, et
**en ce que** les générateurs de signal sont configurés pour détecter si le signal à impulsions de série temporelle unique est présent côté borne normalement ouverte et si le signal à impulsions de série temporelle unique est présent côté borne normalement fermée, de façon à déterminer une défaillance dans le signal à impulsions de série temporelle unique qui est sorti vers le module de réception.

2. Système selon la revendication 1,
dans lequel le module de réception (B) est configuré pour déterminer qu'il y a les certaines informations dans le signal à impulsions de série temporelle unique lorsque le signal à impulsions de série temporelle unique continue sur un intervalle de temps prédéterminé.

3. Système selon la revendication 1 ou 2,
dans lequel les générateurs de signal (1a, 1b) déterminent qu'il n'y a aucune défaillance dans le signal à impulsions de série temporelle unique, si le signal à impulsions de série temporelle unique est seulement sorti depuis la borne normalement ouverte (NO) en pilotant le relais (4) et si le signal à impulsions de série temporelle unique est seulement sorti depuis la borne normalement fermée (NC) en arrêtant le pilotage du relais, et
dans lequel les générateurs de signal déterminent qu'il y a une défaillance dans le signal à impulsions de série temporelle unique, à moins que le signal à impulsions de série temporelle unique ne soit seulement sorti depuis la borne normalement ouverte en pilotant le relais et le signal à impulsions de série temporelle unique est seulement sorti depuis la borne normalement fermée en arrêtant le pilotage du relais.

4. Système selon la revendication 1, 2 ou 3, dans lequel les générateurs de signal (1a, 1b) déterminent qu'il y a une défaillance dans le signal à impulsions de série temporelle unique, si le signal à impulsions de série temporelle unique est sorti tant de la borne normalement ouverte que de la borne normalement fermée en arrêtant le pilotage du relais.
